# EUROPEAN PATENT SPECIFICATION

(11) **EP 0 286 410 B1**
(45) Date of publication and mention of the grant of the patent: **02.03.1994**
(21) Application number: 88303124.7
(22) Date of filing: 07.04.1988
(51) Int. Cl.: H01L 39/24, H01L 39/12, H01F 5/08

(54) **Methods of manufacturing ceramic material superconductors**
Verfahren zur Herstellung keramischer Supraleiter
Méthodes de fabrication de supraconducteurs en céramique

(30) Priority: 07.04.1987 JP 86494/87
(43) Date of publication of application: 12.10.1988
(73) Proprietor: SEMICONDUCTOR ENERGY LABORATORY CO., LTD., Atsugi-shi Kanagawa-ken, 243 (JP)
(72) Inventor: Yamazaki, Shunpei, Setagaya-ku Tokyo (JP)
(74) Representative: Milhench, Howard Leslie

(56) References cited:
- EP-A- 0 306 287
- APPLIED PHYSICS A, vol. 40, no. 4, August 1986, pages 235-239, Springer-Verlag; M. EYETT et al.: "Laser-induced chemical etching of ceramic PbTi1-xZrxO3"
- SOV. PHYS. SOLID STATE, vol. 25, no. 1, January 1983, pages 100-103, American Institute of Physics; S.V. ZAITSEV-ZOTOV et al.: "Superconductivity of BaPb1-xBixO3 films prepared by laser evaporation method"
- JAPANESE JOURNAL OF APPLIED PHYSICS, vol. 20, supplement 20-4, 1981, pages 13-16; M. SUZUKI et al.: "Thin film preparation of superconducting Perovskite-type oxides by rf sputtering"
- APPLIED PHYSICS LETTERS, vol. 51, no. 23, 7th December 1987, pages 1951-1953, American Institute of Physics, New York, NY, US; M. SCHEUERMANN et al.: "Magnetron sputtering and laser patterning of high transition temperature Cu oxide films"
- APPLIED PHYSICS LETTERS, vol. 51, no. 14, 5th October 1987, pages 1112-1114, American Institute of Physics, New York, NY, US; A. INAM et al.: "Pulsed laser etching of high Tc superconducting films"

## Description

### BACKGROUND OF THE INVENTION

This invention relates to methods of manufacturing ceramic material superconductors by light irradiation.

It has been known to use metallic materials such as Nb₃Ge to wind a coil to form a superconducting magnet since such metallic materials have high ductility and malleability. However, such metallic materials do not have a high Tc and to operate as superconductors such metallic materials require the use of liquid helium in order to function as superconductors. In recent years, superconducting ceramics which have a high Tc have attracted the interest of researchers. However, superconducting ceramics which have a high Tc are fragile and have low ductility and malleability and therefore it has been quite impossible to form a superconducting coil from a wire made of such superconducting ceramics.

Applied Physics A, vol 40, no 4, 1986, pp235-239 teaches laser-induced chemical etching of non-superconducting ceramic solid solutions of PbTi₁₋ₓZrₓO₃.

### OBJECTS AND SUMMARY OF THE INVENTION

It is therefore the object of the invention to provide a high Tc superconductor in any desired form and to provide a method of manufacturing a high Tc superconductor in any desired form which method is suitable for mass-production.

It has been found that laser scribing of a ceramic film can be easily achieved since the thermal conductivity of the film is relatively small and the film will undergo sublimation when irradiated.

The present invention resides generally in the concept of providing a layer of a prescribed material on a substrate, treating the said layer by for example thermal oxidation or firing to convert it into a superconducting layer and scribing a pattern into the layer by irradiation in order to obtain a superconducting ceramic with desired characteristics. It is unimportant to the working of the invention whether the pattern is scribed into the layer before or after it is converted into a superconducting layer since the invention takes advantage of the fact that the material forming the layer will undergo sublimation when irradiated by a suitable source and proposes to provide hitherto unobtainable high Tc superconducting structures.

In accordance with one embodiment of the present invention which is described hereinafter, an oxide (or carbonate) mixture for constituting a superconducting ceramic is first deposited in the form of a thin film onto a substrate by sputtering, printing such as screen press printing or other methods. When deposited by sputtering, the resultant film adopts an amorphous or other structure which gives rise to abundant lattice defects and/or imperfections so that the resistivity of the ceramic material is usually rather high. The deposited ceramic film can be transformed into a desired superconducting ceramic by thermal oxidation or firing.

The ceramic film can be processed by laser irradiation before or after firing and can be arranged such that for example a strip of the ceramic material is removed from or remains on the substrate. Any suitable laser can be used to irradiate the layer in order to scribe the desired pattern into the layer and may for example be a YAG laser emitting a circular beam of light with a wavelength of about 1.06 microns pulsed at between 5 and 100 KHz, an excimer laser (KrF, KrCl and so forth), a C0₂ laser or an N₂ laser. When an excimer laser is used, a shaped beam having a circular cross-section with a diameter from 10 to 100 microns is emitted and a beam with a linear cross section typically from 10 to 40 cm wide and from 5 to 100 microns long can be obtained therefrom by expanding and squeezing the circular beam with an optical system.

Further features of the invention are set forth with particularity in the appended claims and will become apparent to those possessed with the relevant skills from consideration of the following description, given with reference to the accompanying drawings, of an exemplary embodiment of the invention.

### BRIEF DESCRIPTION OF THE DRAWINGS

Fig.1 is a perspective view illustrating a first exemplary manufacturing process in accordance with the present invention; and
Fig.2 is a perspective view illustrating a second exemplary embodiment of the manufacturing process in accordance with the present invention.

### DETAILED DESCRIPTION OF THE EMBODIMENTS

For the avoidance of doubt it is to be noted that all references herein and in the appended claims to the Periodic Table and to specific Groups of the Periodic Table are to be understood to refer to the Japanese Periodic Table and to the Groups thereof as described in the Iwanami "Physics and Chemistry Dictionary". As compared with the Group designations of the Periodic Table as described in "The Penguin Dictionary of Science" for example, which are the Group designations commonly accepted throughout Europe, Groups Ia, IIa, VIII, Ib, IIb and 0 are the same in the Japanese and European Periodic Tables, Groups IIIa, IVa, Va, VIa and VIIa of the Japanese Periodic Table correspond respectively to Groups IIIb, IVb, Vb, VIb and VIIb of the European Periodic Table, and Groups IIIb, IVb, Vb, VIb and VIIb of the Japanese Periodic Table correspond respectively to Groups IIIa,, IVa, Va, VIa and VIIa of the European Periodic Table.

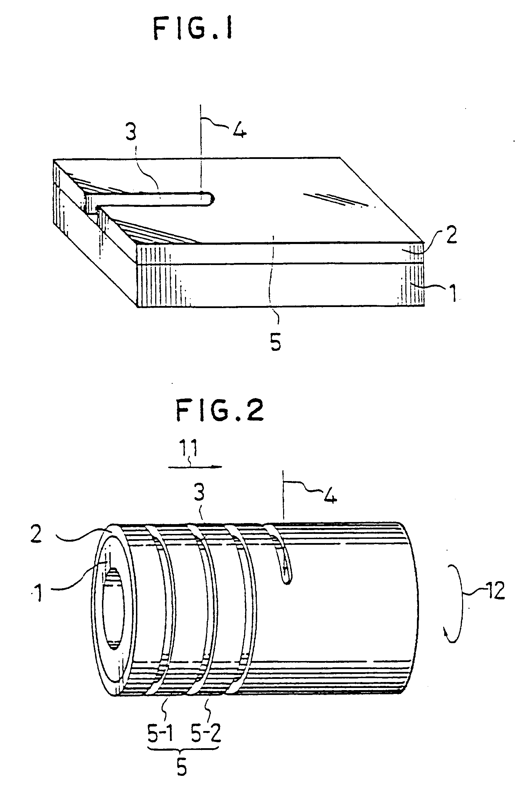

Referring to Fig.1, a manufacturing process in accordance with the present invention will be described. In Fig.1(A), a substrate 1 may be made of a ceramic material such as alumina, silicon oxide, silicon nitride, aluminium nitride, strontium titanate, zirconia, yttria or YSZ(yttria stabilized zircon), or a metal such as copper or a copper alloy or glass. YSZ, yttria or zirconia are particularly suitable having regard to the desirability of matching the coefficient of thermal expansion to that of the layer formed thereon as hereinafter described. In any case the material should be selected so that the differential coefficient of thermal expansion between the underlying substrate and the overlying ceramic thin film should be limited preferably within 50% of the thermal expansion coefficient of the ceramic thin film, since if the thermal expansion coefficients of the substrate and the ceramic thin film are substantially different, then the strain developed between them may hinder the recrystallisation of the ceramic film into a superconducting structure during thermal annealing.

A ceramic film 2 conforming to YBa₂C₃0₆₋₈ of 0.1 to 50 micron thickness, e.g. 20 microns, is formed on the substrate 1 by sputtering or by a printing method such as screen press printing.

Having formed the ceramic film 2 on the substrate 1, the next step is to fire the same at a temperature from 500 to 1000°C e.g. 900°C for 15 hours whereby the ceramic film 2 is transformed into a superconducting structure. Once the structure has thus been prepared a laser beam 1.06 microns in wavelength derived by means of a YAG laser may be used to irradiate parts of the superconducting film 2 in order to produce a pattern thereon. In figure 1, the surface of the film has been scanned from the left edge towards the middle of the structure so as to remove a portion of the film by sublimation and thereby leave a groove 3. To ensure that the portion is removed fully by sublimation the output power of the laser should be from 10⁶ to 10⁷ W/sec; stronger irradiation may damage the underlying substrate 1. Alternatively, the laser patterning can be effected before the structure is fired to transform the ceramic film into a superconducting layer in which oxygen and copper atoms form the structure of the layer.

Each circular pulse emitted from the laser is directed towards a predefined irradiation region on the film which region is common to 60 to 80% of the irradiation region of the preceding pulse (and also of the subsequent pulse). The scanning speed is typically 2m/min. The frequency can be from 5 to 30 KHz, e.g. 10 KHz. Instead of a YAG laser, an excimer laser which is capable of emitting a series of intense laser pulses with a rectangular cross section of for example 20 x 30 mm² can be used in which case, the emitted pulse can be shaped into a linear cross-section 10 cm wide and 50 microns thick. The effect of this irradiation is to selectively remove the irradiated portions of the ceramic film by sublimation. The entire structure can be heated during this laser scribing process to a temperature from 300 to 800°C, e.g. 600°C by a halogen lamp in order to enhance sublimation.

Fig.2 shows a second embodiment of the invention. In this embodiment, substantially the same procedure is repeated as for the preceding embodiment except for the differences described below. In this embodiment, the substrate 1 is a cylinder and a ceramic film 2 is deposited on the substrate 1 while the substrate 1 is rotating the direction indicated by an arrow 12. After the film has been dried a laser beam, 50 microns in diameter, is radiated continuously or repeatedly towards the substrate. The laser beam is shifted towards the right as seen in the drawing (the axial direction of the cylinder 1) while the substrate 1 is rotated around its axis. By this process, a helical groove 3 is scribed into the layer 2 thereby forming a continuous helical superconductor 5 on the cylinder 1. It will be appreciated that each part of the helix 5-1 is isolated from adjacent parts 5-2 by the helical groove 3 which has been removed by the above described laser sublimation scribing process and thus a superconducting electromagnet in the form of a coil is constructed.

When the above described laser scribing process is combined with a laser annealing process a superconductor of superior quality can be obtained. In a laser annealing process, a ceramic film is initially formed on the surface of a substrate by for example sputtering. As mentioned hereinabove the film initially has an amorphous or other non-superconducting structure. By laser annealing, a prescribed portion of the film is melted by irradiation with a laser beam which portion recrystallises into a superconducting atomic structure when cooled. If necessary the whole structure, i.e. the substrate and the ceramic film, may be cooled at the same time. After the prescribed portion has been converted to a superconducting portion, another portion of the ceramic film can be removed by the above described laser sublimation method. In this way, a ceramic pattern composed of superconducting regions and non-superconducting (insulating) regions can be easily obtained since the effect of laser irradiation on the ceramic film, i.e. whether the film is annealed or sublimated, is dependent only on the power or intensity of the laser output.

Superconducting ceramics in accordance with the present invention also may be prepared in accordance with the stoichiometric formulae (A₁₋ₓBₓ)_{y}Cu_{z}0_{w}, where A is one or more elements of Group IIIa of the Japanese Periodic Table, e.g., the rare earth elements, B is one or more elements of Group IIa of the Japanese Periodic Table, e.g. the alkaline earth metals including beryllium and magnesium, and where x = 0 to 1; y = 2.0 to 4.0, with y preferably having a value from 2.5 to 3.5; z = 1.0 to 4.0, with y preferably having a value from 1.5 to 3.5; and w= 4.0 to 10.0, with w preferably having a value from 6.0 to 8.0. One example is YBa₂Cu₃0₆₋₈.

In addition, superconducting ceramics in accordance with the present invention may be prepared in accordance with the stoichiometric formulae (A₁₋ₓBₓ)_{y}Cu_{z}0_{w}, where A is one or more elements of Group Vb of the Periodic Table such as Bi, Sb and As, B is one or more elements of Group IIa of the Periodic Table, e.g. the alkaline earth metals including beryllium and magnesium, and where x = 0.3 to 1; y =2.0 to 4.0, with y preferably having a value from 2.5 to 3.5; 1.0<z<4.0, with z preferably having a value from 1.5 to 3.5; and w=4.0 to 10.0, with w preferably having a value from 6.0 to 8.0. Examples of this general formula are BiSrCaCuCu₂0ₓ and Bi₄Sr₃Ca₃Cu₄0ₓ. Tc onset and Tco samples confirmed consistent with the formula Bi₄Sr_{y}Ca₃Cu₄0ₓ (y is around 1.5) were measured to be 40-60°K, which is not terribly high, but relatively high critical temperatures were obtained with samples conforming to the stoichiometric formulae Bi₄Sr₄Ca₂Cu₄0ₓ and Bi₂Sr₃Ca₂Cu₂0ₓ. The number designating the oxygen proportion is in the range 6 to 10, e.g. around 8.1.

While the above description has been made with reference to several specific embodiments, it is to be understood that the present invention is limited only by the appended claims and is not limited to the particular examples described.

## Claims

1. A method of manufacturing a ceramic material superconductor comprising:
forming a superconducting material ceramic layer on a surface made of a material which has a thermal expansion coefficient of 50% to 150% of that of said ceramic layer, and
irradiating a portion of the ceramic layer with a laser beam so as to cause the irradiated portion of the ceramic layer to be removed from the surface.

2. The method of claim 1 wherein said superconducting ceramic layer forming step comprises depositing said surface by sputtering.

3. The method of any preceding claim wherein said substrate is made of strontium titanate, zirconia, yttria or YSZ (yttria stabilized zircon).

4. The method of any preceding claim wherein said laser beam is applied to the said layer in a sequence of pulses.

5. The method of claim 4 wherein said pulses are radiated on to a portion of said ceramic layer so as to trace a prescribed line thereon.

6. The method of any preceding claim wherein said laser beam is radiated onto said layer so as to form a superconducting coil.

7. The method of claim 6 wherein said surface comprises the periphery of a cylinder which is rotated about its axis during said irradiating step and the location of the said laser beam on the said layer is shifted in the axial direction with respect to said cylinder whereby the laser beam traces a helical path on said layer.

8. The method of any preceding claim, further comprising the step of annealing the layer.

9. The method of any preceding claim in which the ceramic layer is initially treated to convert it into a superconducting ceramic and then patterned by said step of irradiating to remove some of said layer.

10. The method of any of claims 1 to 8 in which the ceramic layer is initially patterned by said step of irradiating and then treated to convert it into a superconducting ceramic.

11. A superconducting component comprising a coil of superconducting ceramic material provided as a deposition layer upon a cylindrical substrate of a material having a thermal coefficient of expansion between 50-150% that of the ceramic material, the coil forming a helical superconducting coil on the lateral area of said cylindrical substrate, each turn of the coil being isolated from adjacent turns of the coil by a helical groove.

## Patentansprüche

1. Verfahren zum Herstellen eines keramischen Supraleiters, umfassend:
- Ausbilden einer Keramikschicht aus supraleitendem Material auf einer Oberfläche aus einem Material, das einen thermischen Expansionskoeffizienten aufweist, der 50 % bis 150 % desjenigen der Keramikschicht beträgt; und
- Bestrahlen eines Teils der Keramikschicht in solcher Weise, daß bewirkt wird, daß der bestrahlte Teil der Keramikschicht von der Oberfläche entfernt wird.

2. Verfahren nach Anspruch 1, bei dem der Herstellschritt für die supraleitende Keramikschicht das Belegen der Oberfläche durch Sputtern umfaßt.

3. Verfahren nach einem der vorstehenden Ansprüche, bei dem das Substrat aus Strontiumtitanat, Zirkoniumdioxid, Yttriumoxid oder YSZ (mit Yttriumoxid stabilisiertes Zirkonium) besteht.

4. Verfahren nach einem der vorstehenden Ansprüche, bei dem der Laserstrahl in einer Impulsfolge auf die Schicht angewandt wird.

5. Verfahren nach Anspruch 4, bei dem die Impulse so auf einen Teil der Keramikschicht gestrahlt werden, daß einer vorgegebenen Linie auf derselben gefolgt wird.

6. Verfahren nach einem der vorstehenden Ansprüche, bei dem der Laserstrahl so auf die Schicht gestrahlt wird, daß eine supraleitende Spule gebildet wird.

7. Verfahren nach Anspruch 6, bei dem die genannte Fläche der Umfang eines Zylinders ist, der während des Bestrahlungsschritts um seine Achse gedreht wird, und daß der Ort des Laserstrahls auf der Schicht in axialer Richtung des Zylinders verschoben wird, wodurch der Laserstrahl einem schraubenförmigen Pfad auf der Schicht folgt.

8. Verfahren nach einem der vorstehenden Ansprüche, ferner mit dem Schritt des Temperns der Schicht.

9. Verfahren nach einem der vorstehenden Ansprüche, bei dem die Keramikschicht anfangs behandelt wird, um sie in eine supraleitende Keramik umzuwandeln, und sie dann durch den Bestrahlungsschritt zum Entfernen eines Teils der Schicht gemustert wird.

10. Verfahren nach einem der Ansprüche 1 bis 8, bei dem die Keramikschicht anfangs durch den Bestrahlungsschritt gemustert wird und dann behandelt wird, um sie in eine supraleitende Keramik umzuwandeln.

11. Supraleitendes Bauteil mit einer Spule aus supraleitendem Keramikmaterial, das als Abscheidungsschicht auf einem zylindrischen Substrat vorliegt, das aus einem Material mit einem thermischen Expansionskoeffizienten zwischen 50 - 150 % desjenigen des Keramikmaterials besteht, wobei die Spule eine schraubenförmige, supraleitende Spule auf der Seitenfläche des zylindrischen Substrats bildet, wobei jede Windung der Spule von benachbarten Windungen der Spule durch eine schraubenförmige Nut getrennt ist.

## Revendications

1. Procédé de fabrication d'un matériau supraconducteur en céramique comprenant :
la formation d'une couche de matériau à base de céramique supraconductrice à la surface d'une matière ayant un coefficient de dilatation thermique de 50 % à 150 % de celui de ladite couche de céramique, et
l'irradiation d'une portion de la couche de céramique par un rayon laser de façon à ce que la portion irradiée de la couche de céramique soit ôtée de la surface.

2. Procédé selon la revendication 1, dans lequel l'étape de formation de ladite couche de céramique supraconductrice comprend le dépôt par pulvérisation sur ladite surface.

3. Procédé selon l'une quelconque des revendications précédentes, dans lequel le substrat est fait de titanate de strontium, de zircone, d'yttrine ou d'YSZ (yttrine-stabilisé-zircon).

4. Procédé selon l'une quelconque des revendications précédentes, dans lequel ledit rayon laser est appliqué à ladite couche par une série d'impulsions.

5. Procédé selon la revendication 4, dans lequel lesdites impulsions sont émises vers une portion de ladite couche de céramique de façon à suivre sur cette couche un tracé bien défini.

6. Procédé selon l'une quelconque des revendications précédentes, dans lequel ledit rayon laser est émis vers ladite couche dans le but de confectionner une bobine supraconductrice.

7. Procédé selon la revendication 6, dans lequel ladite surface comprend la surface périphérique d'un cylindre en rotation autour de son axe pendant ladite étape d'irradiation, et dans lequel le point d'impact dudit rayon laser sur ladite couche se déplace dans la direction de l'axe en restant dirigé sur le cylindre sur lequel par là-même le rayon laser trace un chemin hélicoïdal sur ladite couche.

8. Procédé selon l'une quelconque des revendications précédentes, comprenant en outre l'étape de recuit de la couche.

9. Procédé selon l'une quelconque des revendications précédentes, dans lequel la couche de céramique est traitée initialement pour la convertir en une céramique supraconductrice, pour être ensuite soumise à ladite étape d'irradiation pour enlever une partie de ladite couche selon un tracé.

10. Procédé selon l'une quelconque des revendications 1 à 8, dans lequel la couche de céramique, sur laquelle est d'abord inscrit un tracé schématique lors de l'étape d'irradiation, est ensuite traitée pour la convertir en une céramique supraconductrice.

11. Composant supraconducteur comprenant une bobine en matière à base de céramique supraconductrice constituée d'une couche déposée à la surface d'un substrat fait d'une matière ayant un coefficient de dilatation thermique compris entre 50 et 150 % de celui de la matière à base de céramique, la bobine formant une bobine supraconductrice hélicoïdale sur la surface latérale dudit substrat de forme cylindrique, chaque spire de la bobine étant isolée des spires adjacentes de la bobine par un sillon hélicoïdal.
